(19) Europäisches Patentamt
European Patent Office
Office européen des brevets

(11) **EP 3 398 252 B1**

(12) # FASCICULE DE BREVET EUROPEEN

(45) Date de publication et mention
de la délivrance du brevet:
**26.01.2022 Bulletin 2022/04**

(21) Numéro de dépôt: **16823264.3**

(22) Date de dépôt: **20.12.2016**

(51) Classification Internationale des Brevets (IPC):
**H03H 7/46** (2006.01)   **G01G 3/16** (2006.01)
**G01N 5/02** (2006.01)   **G01N 9/00** (2006.01)
**G01N 29/02** (2006.01)   **G01N 29/34** (2006.01)

(52) Classification Coopérative des Brevets (CPC):
**G01G 3/16; G01N 5/02; G01N 9/002; G01N 29/022;
G01N 29/346; H03H 7/46**

(86) Numéro de dépôt international:
**PCT/EP2016/081853**

(87) Numéro de publication internationale:
**WO 2017/114689 (06.07.2017 Gazette 2017/27)**

(54) **PROCÉDÉ D'AMPLIFICATION PAR UN RÉSONATEUR MÉCANIQUE**

VERSTÄRKUNGSVERFAHREN MIT MECHANISCHEM RESONATOR

AMPLIFICATION METHOD USING A MECHANICAL RESONATOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **28.12.2015 FR 1563388**

(43) Date de publication de la demande:
**07.11.2018 Bulletin 2018/45**

(73) Titulaire: **Centre National de la Recherche
Scientifique**
**75016 Paris (FR)**

(72) Inventeurs:
* **COLLIN, Eddy**
**38500 Coublevie (FR)**
* **DEFOORT, Martial**
**38000 Grenoble (FR)**
* **ARMOUR, Andrew**
**Nottingham NG7 2RD (GB)**

(74) Mandataire: **IPAZ**
**Parc Les Algorithmes, Bâtiment Platon
CS 70003 Saint-Aubin
91192 Gif-sur-Yvette Cedex (FR)**

(56) Documents cités:
**US-A1- 2014 312 980**

* M Defoort ET AL: "Modal "self-coupling" as a sensitive probe for nanomechanical detection", , 23 novembre 2015 (2015-11-23), XP055302662, DOI: 10.1063/1.4812718 Extrait de l'Internet: URL:https://arxiv.org/pdf/1511.07273.pdf [extrait le 2016-09-15]
* LULLA K J ET AL: "Nonlinear modal coupling in a high-stress doubly-clamped nanomechanical resonator", NEW JOURNAL OF PHYSICS, INSTITUTE OF PHYSICS PUBLISHING, BRISTOL, GB, vol. 14, no. 11, 28 novembre 2012 (2012-11-28), page 113040, XP020231699, ISSN: 1367-2630, DOI: 10.1088/1367-2630/14/11/113040
* M. DEFOORT ET AL: "Scaling laws for the bifurcation escape rate in a nanomechanical resonator", PHYSICAL REVIEW E (STATISTICAL, NONLINEAR, AND SOFT MATTER PHYSICS), vol. 92, no. 5, 23 novembre 2015 (2015-11-23), page 70, XP055302673, US ISSN: 1539-3755, DOI: 10.1103/PhysRevE.92.050903
* COLLIN E ET AL: "In-situ comprehensive calibration of a tri-port nano-electro-mechanical device", REVIEW OF SCIENTIFIC INSTRUMENTS, AIP, MELVILLE, NY, US, vol. 83, no. 4, 1 avril 2012 (2012-04-01), pages 45005-45005, XP012162246, ISSN: 0034-6748, DOI: 10.1063/1.4705992 [extrait le 2012-04-30]

## Description

### Domaine de l'invention

L'invention porte sur un amplificateur électromécanique et un procédé d'amplification électromécanique apte à préserver la linéarité de l'amplification.

### Etat de la Technique

Les micro et nano-systèmes électromécaniques (respectivement MEMS et NEMS) permettent la détection de composés chimiques ou biologiques jusqu'à des seuils de détection extrêmement bas, par exemple de l'ordre de l'attogramme, lorsqu'ils sont utilisés comme des résonateurs. Lors de l'interaction d'un micro ou nano-système oscillant avec un composé chimique ou biologique, les caractéristiques mécaniques du résonateur peuvent varier : la mesure d'une variation de l'amplitude de l'oscillateur, ou de la variation d'une fréquence d'un mode de l'oscillateur peuvent permettre la détection du ou des composés.

Les résonateurs de type MEMS et NEMS ont un rapport d'aspect plus élevé que des résonateurs macroscopiques. L'augmentation du rapport d'aspect d'un résonateur mécanique favorise l'apparition de phénomènes non-linéaires lors de l'oscillation du résonateur (Postma, H. C., Kozinsky, I., Husain, A., & Roukes, M. L. (2005). Dynamic range of nanotube-and nanowire-based electromechanical systems. Applied Physics Letters, 86(22), 223105). Ainsi, pour une large gamme d'amplitudes, un résonateur aux échelles micro ou nanométriques suit un comportement dit de « Duffing », c'est-à-dire qui suit l'équation suivante :

$$\ddot{x} + \Delta\omega\,\dot{x} + \omega_0^2\,x + \gamma\,x^3 = \frac{F_L}{m}$$

(1)

où x est l'amplitude du signal mesuré, $\omega_0$ la pulsation de résonance, $\Delta\omega$ la dissipation liée au mouvement du résonateur, $F_L$ la force transduite au résonateur, m la masse du résonateur et $\gamma$ le coefficient non-linéaire, connu comme « coefficient de Duffing ». L'homme du métier retrouve l'équation connue d'un oscillateur harmonique ayant une résonance qui suit une courbe de Lorentz, quand le coefficient $\gamma=0$.

La non-linéarité dans le comportement d'un oscillateur pose des problèmes dans la mise en œuvre d'une détection : un transducteur électromécanique est typiquement un oscillateur MEMS ou NEMS apte à fonctionner dans un régime linéaire. A défaut, une bi-stabilité mécanique ou une hystérésis lors d'une oscillation peut compromettre la transmission d'un stimulus à détecter. En effet, si l'amplitude d'oscillation n'est pas trop grande, une non-linéarité de type Duffing (qui suit l'équation de Duffing) déforme la résonance, et donne lieu à une forme de résonance connue comme résonance de type Duffing. Si l'amplitude d'oscillation est très grande, le système entre dans un régime bistable qui, dans la plupart des applications, compromet drastiquement la transmission d'un stimulus qui doit être détecté.

Une des solutions pour éviter les non-linéarités des oscillations du résonateur peut consister à exciter le résonateur avec des forces suffisamment faibles pour rester dans un régime linéaire. En pratique, l'amplitude des oscillations mesurées lors d'une résonance est souvent trop faible pour discriminer un signal par rapport au bruit de mesure, ou mesurer des variations de manière quantitative.

Une autre solution consiste à exciter un résonateur avec des forces aptes à induire une amplitude suffisamment grande pour être détectée mais en induisant également un comportement non-linéaire, qui doit être corrigé. Une grille couplée par des polarisations électriques au résonateur est utilisée pour compenser les non-linéarités de la dynamique du résonateur (Kacem, N., Hentz, S., Pinto, D., Reig, B., & Nguyen, V. (2009). Nonlinear dynamics of nanomechanical beam resonators: improving the performance of NEMS-based sensors. Nanotechnology, 20(27), 275501). Lors de l'implémentation de cette solution, des simulations numériques coûteuses en calcul et en temps sont nécessaires pour trouver les paramètres expérimentaux adéquats à la compensation des non-linéarités. Aussi, l'implémentation d'une ou plusieurs grilles doit être tolérée par le mode d'utilisation du résonateur.

D'autres solutions sont divulguées dans les publications :

   a) M Defoort et al: "Modal "self-coupling" as a sensitive probe for nanomechanical détection", 23 novembre 2015, URL:https://arxiv.org/pdf/1511.07273.pdf;
   b) K J Lulla et al: "Nonlinear modal coupling in a high-stress doubly-clamped nanomechanical resonator", New Journal of Physics, Institute of Physics Publishing, Bristol, GB, vol. 14, no. 11, 28 novembre 2012, page 113040, ISSN: 1367-2630; et
   c) US 2014/312980 A1.

L'invention vise à remédier aux inconvénients précités de l'art antérieur, et plus particulièrement vise à actionner le résonateur dans une plage de fréquences donnée, proche de sa fréquence de résonnance, proportionnellement à une force d'excitation, dans la gamme d'amplitude la plus large possible et particulièrement dans une gamme d'amplitude dans laquelle le résonateur oscille habituellement suivant l'équation dite de Duffing explicitée précédemment, tout en préservant sa linéarité, afin que sa résonance mécanique, dans cette plage de fréquence, suive une courbe de Lorentz et que le signal détecté soit proportionnel au signal injecté.

## Résumé de l'invention

Le problème ci-dessus mentionné est résolus, suivant l'invention, à l'aide d'un procédé d'amplification selon la revendication 1 et un système selon la revendication 2. Des caractéristiques optionnelles du système sont définies dans les revendications dépendantes 3-7.

## Description des figures

La description suivante présente plusieurs exemples de réalisation du dispositif de l'invention : ces exemples sont non limitatifs de la portée de l'invention. Ces exemples de réalisation présentent à la fois les caractéristiques essentielles de l'invention ainsi que des caractéristiques additionnelles liées aux modes de réalisation considérés. Par souci de clarté, les mêmes éléments porteront les mêmes repères dans les différentes figures.

L'invention sera mieux comprise et d'autres avantages, détails et caractéristiques de celle-ci apparaîtront au cours de la description explicative qui suit, faite à titre d'exemple en référence aux dessins annexés dans lesquels :

- la figure 1 illustre un amplificateur électromécanique linéaire selon un mode de réalisation de l'invention ;

- la figure 2 est un ensemble de photographies obtenues au moyen d'un microscope électronique illustrant des résonateurs selon plusieurs modes de réalisation de l'invention ;

- la figure 3 illustre schématiquement la déformée d'un résonateur doublement encastré, en vue de coupe, lors d'un mouvement entraîné par deux forces d'excitation appliquées à deux fréquences de modes distincts ;

- la figure 4 illustre schématiquement des résonances proches de la pulsation propre d'un mode mécanique du résonateur ;

- la figure 5 illustre des amplitudes d'un résonateur mesurées en fonction de la fréquence d'oscillation, dans le cas de l'excitation du résonateur par le signal de pompe seul et dans le cas de l'excitation par le signal d'entrée seul ;

- la figure 6 illustre l'amplitude d'un résonateur en fonction de la fréquence d'oscillation, le résonateur étant actionné selon un mode de réalisation de l'invention ;

- la figure 7 illustre une amplification linéaire selon un mode de réalisation de l'invention ;

- la figure 8 illustre les étapes du procédé d'amplification électromécanique de l'invention selon un mode de réalisation.

## Description détaillée de l'invention

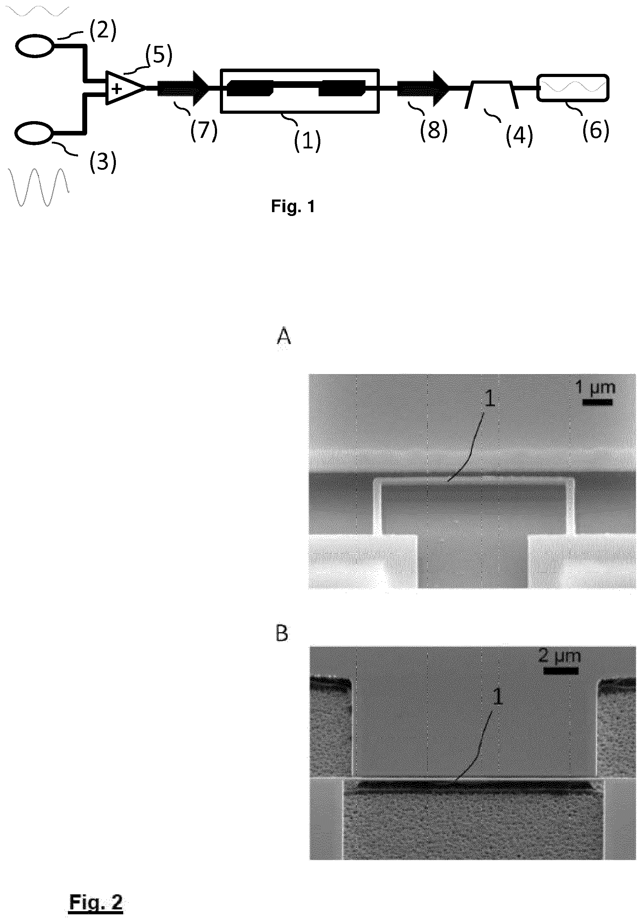

La figure 1 illustre un amplificateur électromécanique selon un mode de réalisation de l'invention. L'amplificateur comporte un résonateur mécanique 1, comprenant au moins un mode de résonance mécanique de pulsation $\omega_0$. L'amplificateur comporte un additionneur 5 apte à additionner deux signaux électriques. Un premier signal 2, dit d'entrée est caractérisé par une pulsation $\omega_s$, proche de $\omega_0$. Un second signal 3, dit de pompe, est caractérisé par une pulsation $\omega_p$,

proche de $\omega_0$ et différente de $\omega_s \left( \frac{\omega_p{}^2 - \omega_0{}^2}{2\omega_p} \approx \delta_p, \frac{\omega_s{}^2 - \omega_0{}^2}{2\omega_s} \approx \delta_p, \frac{\beta}{\omega_p} \approx \frac{\beta}{\omega_s} \approx \frac{\beta}{\omega_0} \text{ avec } \beta = \frac{3\gamma}{8\omega_0} \right)$.

L'amplificateur comporte également un filtre 4 adapté à filtrer des signaux électriques avec un haut facteur de qualité. Dans un mode de réalisation de l'invention, on utilise un filtre passe-bande. La bande passante du filtre 4 est centrée sur la pulsation $\omega_0$ du résonateur mécanique ou sur une pulsation de $\omega_p + \delta_s$.

Dans un mode de réalisation de l'invention, le filtre passe-bande permet de transmettre sélectivement les signaux dans une plage de pulsation centrée sur $\omega_s$ sans transmettre les signaux dans une plage de pulsations centrée

sur $\omega_0$ et/ou $\omega_p$. Dans des modes de réalisation de l'invention, le facteur de qualité du filtre est préférentiellement supérieur ou égal à $\omega_0/(\omega_p - \omega_s)$. Dans un mode de réalisation de l'invention, le filtre passe-bande utilisé est une détection synchrone. La bande passante du filtre 4 est choisie de telle sorte que le signal en sortie du filtre 4 présente une amplitude qui dépend linéairement dudit signal d'entrée 2. Cette caractéristique est expliquée dans la suite de la description.

L'amplificateur comporte également un premier système de transduction électromécanique (7) relié d'une part électriquement à la sortie de l'additionneur 5 et d'autre part mécaniquement au résonateur mécanique 1. Il comporte également un second système de transduction (8) connecté d'une part mécaniquement au résonateur 1 et d'autre part au filtre 4. Le premier et le second système de transduction sont implémentés dans les MEMS ou NEMS. Dans des modes de réalisations, ils peuvent être réalisés par des systèmes piézoélectriques, piézorésistifs, capacitifs et/ou magnétomoteurs.

La figure 2 est un ensemble de photographies obtenues au moyen d'un microscope électronique illustrant des résonateurs 1 selon plusieurs modes de réalisation de l'invention. Dans des modes de réalisations particuliers de l'invention, le résonateur peut être un microsystème et/ou un nano-système. Par microsystème, on entend un système dont la plus petite dimension caractéristique est comprise dans une plage allant de 1 $\mu$m à 1000 $\mu$m inclus. Par nano-système, on entend un système dont la plus petite dimension caractéristique est comprise dans une plage allant de 1 nm à 1000 nm inclus.

Le panneau A de la figure 2 est une photographie d'un résonateur de type NEMS en forme de portique ou d'arceau. La partie centrale mesure 7 $\mu$m de long, ses parties latérales mesurent 3 $\mu$m de long. Il comporte une couche de silicium de 150 nm d'épaisseur sur laquelle est déposée une couche d'aluminium de 30 nm d'épaisseur. Le panneau B de la figure 2 est une photographie d'un résonateur de type NEMS en forme de poutre doublement encastrée. Le résonateur mesure 15 $\mu$m de longueur. Il comporte une couche de nitrure de silicium de 100 nm d'épaisseur sur laquelle est déposée une couche d'aluminium de 30 nm d'épaisseur. Dans un mode de réalisation de l'invention, non représenté, le résonateur mécanique 1 choisi peut être une membrane.

Dans un mode de réalisation préférentiel de l'invention, plusieurs éléments choisis parmi le résonateur 1, le filtre 4, le premier transducteur, le second transducteur et l'additionneur sont monolithiques ou intégrés, c'est-à-dire fabriqués à partir d'un même substrat, par exemple un substrat de silicium.

Dans un mode de réalisation de l'invention, le résonateur est placé dans une enceinte refroidie à très basse température. On peut remplir une première enceinte avec de l'azote liquide. Une deuxième enceinte, agencée à l'intérieur de la première enceinte, peut contenir de l'hélium liquide et conditionner la température du résonateur à 4.2 Kelvin.

Le vide peut aussi être fait à l'intérieur d'une cellule comprenant le résonateur 1. On peut créer un vide partiel au moyen d'une pompe pour atteindre une pression de $10^{-4}$ mbar. En refroidissant la cellule tel que décrit précédemment, le gaz restant dans la cellule peut-être adsorbé aux parois et permettre un vide plus poussé (par cryo-pompage) : la pression de l'enceinte peut être de $10^{-6}$ mbar.

Dans un mode de réalisation de l'invention, l'amplificateur électromécanique comporte un générateur électrique adapté à générer un signal de pompe 3. Le générateur utilisé dans un mode de réalisation de l'invention est le Tektronix AFG 3252 et peut atteindre une fréquence de 240 MHz.

Dans un mode de réalisation de l'invention, l'amplificateur comprend un générateur de champ magnétique homogène. Ce générateur peut être une bobine, entourant l'une des enceintes décrites précédemment. La bobine peut être réalisée par l'enroulement d'un ou plusieurs fils d'un alliage de niobium-titane supraconducteur et permet d'imposer au résonateur 1 un champ magnétique pouvant atteindre une densité du flux magnétique de 1 Tesla typiquement. En reliant électriquement le signal électrique en sortie de l'additionneur 5 au résonateur, des forces de Laplace sont induites sur les éléments de poutre ou de portique, selon une mise en œuvre décrite dans Cleland, A. N., & Roukes, M. L. (1999), External control of dissipation in a nanometer-scale radiofrequency mechanical resonator, Sensors and Actuators A: Physical, 72(3), 256-261. Le premier transducteur est adapté à transduire de l'énergie électromagnétique en énergie mécanique par un travail des forces de Laplace ou de Lorentz. Dans d'autres modes de réalisation de l'invention, on peut utiliser des transducteurs piézoélectriques, capacitifs, électrostatiques et/ou thermoélectriques.

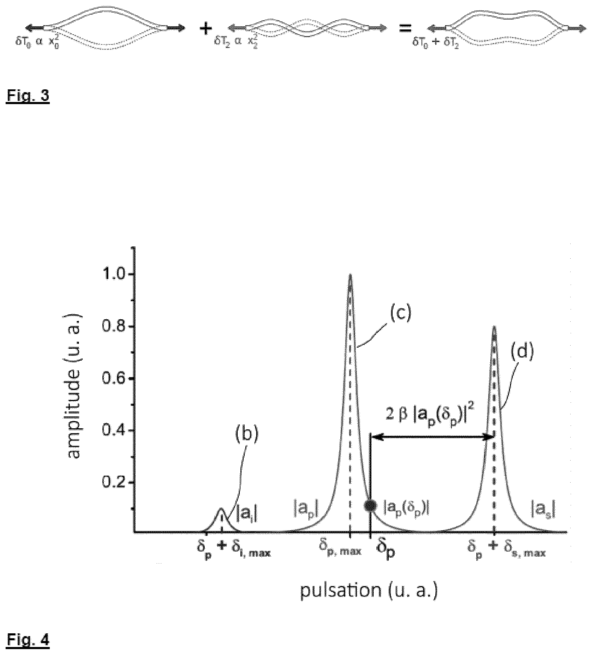

La figure 3 illustre schématiquement la déformée d'un résonateur 1 doublement encastré, en vue de coupe, lors d'un mouvement entraîné par deux forces d'excitation appliquées à des fréquences très différentes, chacune correspondant à un mode différent. Un résonateur 1 peut être excité simultanément à ces différents modes. Ces modes sont indépendants lors d'une oscillation dans un régime linéaire, et sont couplés lors d'une oscillation dans un régime non-linéaire. D'après la forme canonique de la non-linéarité de Duffing (équation 1) il est possible de les coupler dans le même résonateur de manière dispersive (Westra, H. J. R., Poot, M., Van der Zant, H. S. J., & Venstra, W. J. (2010). Nonlinear modal interactions in clamped-clamped mechanical resonators. Physical Review Letters, 105(11), 117205.).

L'excitation d'un résonateur idéal à sa fréquence de résonance entraîne des oscillations à une amplitude donnée. Pour de fortes amplitudes, ces oscillations exercent des contraintes sur le matériau du résonateur. Quand l'amplitude d'excitation augmente, le pic de résonance varie en fréquence et modifie l'allure de la courbe décrivant l'amplitude en fonction de la fréquence, d'une allure Lorentzienne en régime linéaire, à une allure dite de Duffing pour de plus hautes amplitudes. Cette propriété existe pour tous les modes d'un résonateur, chaque mode ayant un coefficient de Duffing (non-linéaire) $\gamma_\eta$, n étant l'ordre du mode.

Si deux modes sont excités à des amplitudes assez élevées, un comportement similaire est observé. La contrainte générée par l'amplitude de l'oscillation d'un mode affecte les propriétés mécaniques de l'ensemble du résonateur. L'autre mode est alors affecté, et *vice versa.*

Dans la figure 3, le résonateur est excité au mode fondamental à la fréquence $f_0$ d'amplitude $x_0$ et au second harmonique à la fréquence $f_2$ d'amplitude $x_2$. La forme dynamique du résonateur est définie par les deux excitations, couplées par les termes de tension $\delta T_0$ (proportionnel à $x_0^2$) et $\delta T_2$ (proportionnel à $x_2^2$).

On peut résoudre l'équation 1 sous la forme suivante, dans le cas où une seule force d'excitation est appliquée :

$$x = \frac{F_L}{2\,m\,\omega_0} \frac{1}{(\omega_0 + \beta\,x^2 - \omega) + i\,\frac{\Delta\omega}{2}} \qquad (2)$$

avec $\beta = \frac{3\gamma}{8\omega_0}$ et $\gamma$ le coefficient de Duffing. On utilise la notation $\gamma = \gamma_\eta$ lorsqu'un seul mode n est concerné.

Le couplage entre modes est dérivé théoriquement de la théorie des poutres (Lulla, K. J., Cousins, R. B., Venkatesan, A., Patton, M. J., Armour, A. D., Mellor, C. J., & Owers-Bradley, J. R. (2012), Nonlinear modal coupling in a high-stress doubly-clamped nanomechanical resonator, New Journal of Physics, 14(11), 113040) par les inventeurs. On peut en déduire le couplage dispersif suivant entre les deux modes :

$$\omega_n = \omega_{0,\,n} + \beta_n\,x_n^2 + \beta_{n,m}\,x_m^2 \qquad (3)$$

où $\omega_n$ est la pulsation de résonance du mode n lors d'une résonance d'allure de Duffing, $\omega_{0,n}$ la pulsation de résonance du mode n en l'absence de couplage, et comprenant le terme de Duffing $\beta n\,x_n^2$, où $\beta n = \frac{3\gamma_n}{8\omega_{0,n}}$ et $x_n$ l'amplitude du mode n. Le couplage avec le mode m est lié au terme quadratique $\beta_{n,m}\,x_m^2$ (avec $x_m$ l'amplitude du mode m). Le coefficient non-linéaire $\beta_{n,m}$ est donné par :

$$\beta_{n,m} = \frac{1}{4\pi} \frac{E}{l^3\sqrt{\rho\frac{T}{e\,w}}} \times \left( \frac{\int_l \Psi_n'^2(z)\,dz \int_l \Psi_m'^2(z)\,dz}{2} + \left( \int_l \Psi_n'(z)\,\Psi_m'(z)\,dz \right)^2 \right) \qquad (4)$$

avec $\Psi_n'$ la dérivée spatiale de la déformée du résonateur pour le mode n.

L'origine du couplage est visible dans le terme $\gamma\,x^3$ de l'équation 1, et aucun des deux modes ne doit être nécessairement dans un régime non-linéaire.

L'équation 3 ne fait pas d'hypothèse sur le couple (n,m), et théoriquement, n peut être égal à m. On peut donc théoriquement coupler un mode avec lui-même, ce qui définit la technique d'auto-couplage. Cette technique est précisément utilisée dans l'ensemble des modes de réalisation de l'invention. Cet effet est différent des effets précédemment décrits : dans l'auto-couplage, au moins deux signaux d'excitation harmoniques excitent un seul mode n, alors que l'on décrit, par exemple en formule 1 un effet dans lequel un signal d'excitation harmonique excite un mode n.

On utilise dans l'ensemble des modes de réalisation de l'invention deux signaux, le signal d'entrée 2 et le signal de pompe 3, adaptés à exciter le *même mode* après addition et transduction électromécanique, à des pulsations proches mais différentes. L'équation 1 permet d'écrire :

$$\ddot{x} + \Delta\omega\,\dot{x} + \omega_0\,x + \gamma\,x^3 = f_{L,p}\cos(\omega_p\,t) + f_{L,s}\cos(\omega_s\,t + \delta\phi) \qquad (5)$$

où $f_{L,p}$ et $f_{L,s}$ sont respectivement la force de signal d'entrée correspondant à la transduction de la composante du signal d'entrée 2, et la force de pompe correspondant à la transduction de la composante du signal de pompe 3 (normalisées à la masse du mode), entrainant le résonateur 1 respectivement aux pulsations $\omega_s$ et $\omega_p$, avec $\omega_s$ différent de $\omega_p$ et avec $\delta\phi$ la différence de phase entre les deux signaux. Le signal électrique provenant de l'additionneur 5 est transduit en un signal mécanique, dont $f_{L,s}$ et $f_{L,p}$ sont deux composantes. L'additionneur 5 peut être réalisé par une combinaison de résistances et de capacités et/ou d'un amplificateur opérationnel, qui peuvent être intégrés à une puce de manière monolithique. On peut définir pour la clarté des notations :

$$\omega_p = \omega_0 + \delta_p \qquad (6)$$

$$\omega_s = \omega_p + \delta_s \qquad (7)$$

où $\delta_s$ et $\delta_p$ sont les paramètres de balayage relatifs à $\omega_0$. Par construction, $\delta_p$ et $\delta_s$ sont différents de 0.

Une solution générale $x_0$ de l'équation 5 peut s'écrire sous la forme :

$$x_0 = \frac{X_0\, e^{i\,\omega_p\, t} + X_0^\star\, e^{-i\,\omega_p\, t}}{2} \qquad (8)$$

En remplaçant $\beta = \frac{3\gamma}{8\omega_0}$ dans l'équation 5 on obtient :

$$\dot{X}_0 = -\left(\frac{\Delta\omega}{2} + i\,\delta_p\right) X_0 + i\,\beta\, X_0^2\, X_0^\star + \frac{1}{2\,i\,\omega_0}\left(f_{L,p} + f_{L,s}\, e^{i\,\delta_s\, t + \delta\phi}\right) \qquad (9)$$

où $X_0$ est une variable lente ($\dot{X}_0 \ll \omega_0 X_0$), l'hypothèse de haut facteur de qualité est valide ($\Delta\omega \ll \omega_0$) et où l'on travaille dans une plage de fréquences proche de la fréquence de résonance $\left(\frac{\omega_p{}^2 - \omega_0{}^2}{2\omega_p} \approx \delta_p, \frac{\beta}{\omega_p} \approx \frac{\beta}{\omega_0}\right)$. Au premier ordre, on peut résoudre l'équation 9 avec la forme suivante de $X_0$ :

$$X_0 = a_p + a_s\, e^{i\,\delta_s\, t} + a_i\, e^{-i\,\delta_s\, t} \qquad (10)$$

avec $a_p$, $a_s$ et $a_i$ les amplitudes complexes des différentes composantes du mouvement, caractéristiques de la résonance mécanique du mode, respectivement aux fréquences $\omega_p$, $\omega_p + \delta_s$, et $\omega_p - \delta_s$, où $a_p$ est le terme principal gouverné principalement par $f_{L,p}$ (la force de pompe, résonant à $\omega_0 + \delta_{p,max}$), $a_s$ principalement gouverné par $f_{L,s}$ (la force de signal d'entrée, résonant à $\omega_p + \delta_{s,max}$) et $a_i$, l'image de $a_s$ symétriquement à $a_p$ (le signal complémentaire, résonant à $\omega_p\, \delta_{i,max}$).

La figure 4 illustre schématiquement des résonances proches de la pulsation $\delta_{p,max}$ (pulsation de bifurcation réduite) translatée de $\omega_0$. En introduisant les termes de l'équation 10 dans l'équation 9 et en utilisant une approximation d'onde rotative, on obtient le système d'équations suivant pour les différentes composantes des pulsations relatives à $\omega_p$ :

$$e^{i\,0}: \quad a_p = \frac{f_{L,p}}{2\,\omega_0} \frac{1}{\beta\,|a_p|^2 - \delta_p + i\,\frac{\Delta\omega}{2}} \qquad (11)$$

$$e^{i\,\delta_s}: \quad a_s = \frac{\frac{f_{L,s}\, e^{i\,\delta\phi}}{2\,\omega_0} - \beta\, a_p^2\, a_i^\star}{2\,\beta\,|a_p|^2 - \delta_p - \delta_s + i\,\frac{\Delta\omega}{2}} \qquad (12)$$

$$e^{-i\,\delta_s} \quad : \quad a_i = \frac{-\beta\,a_p^2\,a_s^{\star}}{2\,\beta\,|a_p|^2 - \delta_p + \delta_s + i\,\frac{\Delta\omega}{2}} \tag{13}$$

En isolant chacune des variables et en les exprimant comme des fonctions de $a_p$, on obtient finalement :

$$a_p = \frac{f_{L,p}}{2\,\omega_0}\,\frac{1}{\beta\,|a_p|^2 - \delta_p + i\,\frac{\Delta\omega}{2}} \tag{14}$$

$$a_s = \frac{f_{L,s}\,e^{i\,\delta\phi}}{2\,\omega_0}\,\frac{1}{2\,\beta\,|a_p|^2 - \delta_p - \delta_s + i\,\frac{\Delta\omega}{2} - \dfrac{\beta^2\,|a_p|^4}{2\,\beta\,|a_p|^2 - \delta_p + \delta_s - i\,\frac{\Delta\omega}{2}}} \tag{15}$$

$$a_i = \frac{f_{L,s}\,e^{-i\,\delta\phi}}{2\,\omega_0}\,\frac{1}{2\,\beta\,|a_p|^2 - \delta_p + \delta_s + i\,\frac{\Delta\omega}{2} - \dfrac{\beta^2\,|a_p|^4}{2\,\beta\,|a_p|^2 - \delta_p - \delta_s - i\,\frac{\Delta\omega}{2}}}$$

$$\times \frac{\beta\,a_p^2}{2\,\beta\,|a_p|^2 - \delta_p - \delta_s - i\,\frac{\Delta\omega}{2}}. \tag{16}$$

On observe alors que l'équation 14 est similaire à l'équation 2 avec $\delta_p = \omega_p - \omega_0$ étant le paramètre de balayage pour la composante $a_p$. La résonance à la pulsation $\omega_p$ est une résonance de Duffing. On remarque que l'équation 14 est non-linéaire par rapport à $a_p$, alors que l'équation 15 est linéaire par rapport à $a_s$ et que l'équation 16 est linéaire par rapport à $a_i$. Selon un mode de réalisation de l'invention, on peut actionner le résonateur 1 en additionnant le signal d'entrée 2 et le signal de pompe 3, par exemple au moyen de l'additionneur 5, et transduire le signal électrique résultant au résonateur 1 sous forme de signal mécanique, comportant les composantes $f_{L,s}$ et $f_{L,p}$. Au moins une des amplitudes des signaux en entrée de l'additionneur 5 (signal d'entrée 2 et/ou signal de pompe 3) présente une amplitude suffisante pour actionner ledit résonateur 1 en régime non-linéaire, et plus particulièrement en régime de Duffing, au moins dans une première plage de pulsations proches de $\omega_0$. Typiquement, c'est le signal de pompe 3 qui présente cette amplitude. Dans l'ensemble des modes de réalisation de l'invention, l'amplitude des oscillations du résonateur est linéaire dans une seconde plage de pulsations proches de $\omega_p$, dans une plage comprenant la résonance du signal $a_s$ et/ou $a_i$. En particulier, l'allure de l'amplitude des oscillations en fonction de la seconde plage de pulpations peut être Lorentzienne.

La différence $\delta_s$ définie par $\omega_s - \omega_p$ est au moins cinquante fois inférieure à $\omega_0$, la différence $\delta_p$ définie par $\omega_p - \omega_0$ est au moins cinquante fois inférieure à $\omega_0$, et $\omega_p$ est différent de $\omega_s$.

La norme des différentes composantes $a_p$, $a_s$ et $a_i$ est illustrée dans la figure 4 en fonction d'une pulsation relative à $\delta_{p,max}$, respectivement par les courbes (b), (c) et (d). Le terme principal correspondant à $|a_p|$ est centré en pulsation sur $\delta_{p,max}$, un terme correspondant à $|a_s|$ est centré sur $\delta_p + \delta_{s,max}$ et un troisième terme correspondant à $|a_i|$ est centré sur $\delta_p + \delta_{i,max}$. L'actionnement du résonateur 1 entraîne une amplitude des oscillations du résonateur 1 variant linéairement avec le signal d'entrée 2 sensiblement à la pulsation $\omega_p +$ On mesure une amplitude de l'oscillation, dite amplitude de sortie, du résonateur mécanique 1 sensiblement à la pulsation $\omega_p + \delta_s$. Dans différents modes de réalisation de l'invention, on peut mesurer l'amplitude du résonateur par mesure d'une variation capacitive et/ou par mesure d'une déviation d'un signal optique. Dans une mode de réalisation de l'invention, on peut mesurer une pluralité d'amplitudes du résonateur, dans une plage de pulsations proches de $\omega_p + \delta_s$. On peut utiliser préférentiellement un filtre 4 passe-bande de haut facteur de qualité dont la bande passante est centrée sur une pulsation proche de $\omega_0$ et préférentiellement sensiblement de $\omega_p + \delta_s$. Dans des modes de réalisation particuliers de l'invention, un tel filtre peut être fabriqué de manière intégrée sur une puce. Un filtre 4 passe-bande peut être réalisé par une combinaison connue de l'homme du métier de résistances et de capacités, et/ou de composants actifs, comme par exemple des amplificateurs opérationnels et/ou une détection synchrone.

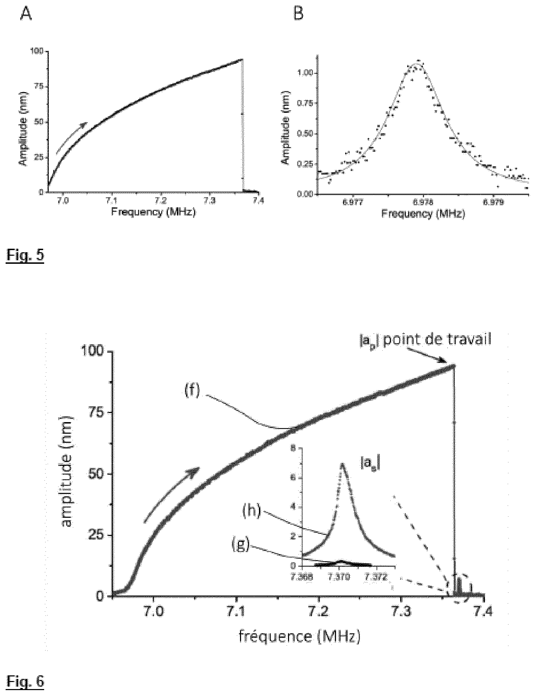

La figure 5 illustre des amplitudes du résonateur 1 mesurées dans le cas de l'excitation du résonateur 1 par le signal de pompe 3 seul (panneau A) et dans le cas de l'excitation par le signal d'entrée 2 seul (panneau B). Dans les panneau A et B de la figure 5, on a $f_{L,s} \ll f_{L,p}$ et plus particulièrement $m\, f_{L,P} = 100\, m\, f_{L,S} = 6{,}4\, pN$ (m étant la masse du mode). La force d'entraînement liée au signal de pompe 3 excite le résonateur 1 avec une dynamique non-linéaire, illustrée dans le panneau A, alors que la force d'entraînement liée au signal d'entrée 2 excite le résonateur 1 de manière linéaire. Le rapport des amplitudes entre l'amplitude maximum mesurée dans le panneau A et dans le panneau B n'est pas exactement de 100 en raison d'effets non-linéaires dans la composante dissipative $\Delta\omega$ propre au matériau du résonateur 1.

Dans le cas où les forces $f_{L,s}$ et $f_{L,p}$ illustrées en figure 5 sont générée simultanément et auto-couplées par le résonateur 1, on peut réécrire l'équation 15 sans négliger les termes non-linéaires en $a_p$ tout en négligeant les termes non-linéaires en $a_s$. En redistribuant le terme du quatrième ordre au dénominateur, on obtient l'équation suivante :

$$a_s = \frac{f_{L,s}\, e^{i\,\delta\phi}}{2\,\omega_0}$$

$$\times \frac{1}{2\,\beta\, |a_p|^2\, (1 - |A_0|^2) - \delta_p\, (1 - |A_0|^2) - \delta_s\, (1 + |A_0|^2) + i\, \frac{\Delta\omega}{2}\, (1 - |A_0|^2)} \quad (17)$$

avec :

$$A_0 = \frac{\beta\, |a_p|^2}{2\,\beta\, |a_p|^2 - \delta_p + \delta_s + i\, \frac{\Delta\omega}{2}} \quad (18)$$

ce qui permet d'obtenir :

$$a_s = \frac{f_{L,s}\, e^{i\,\delta\phi}}{2\,\omega_0}\, \frac{1}{1 - |A_0|^2}\, \frac{1}{2\,\beta\, |a_p|^2 - \delta_p - \delta_s\, \left(\frac{1 + |A_0|^2}{1 - |A_0|^2}\right) + i\, \frac{\Delta\omega}{2}} \quad (19)$$

L'équation 19 est équivalente à l'équation 15 pour $A_0 \approx 0$. L'amplitude de pompe $a_p$ peut-être contrôlée lors des réalisations de l'invention par deux paramètres : la force réduite $f_{L,p}$ et la pulsation d'excitation $\omega_p$ (ou en unité réduites $\delta_P$). Pour une force d'excitation liée au signal de pompe 3 donnée, l'amplitude $a_p$ peut être maximisée en approchant $\delta_p$ le plus près possible du maximum en amplitude de la résonance de Duffing, en choisissant toujours la branche d'amplitude maximum lors d'une résonance bistable du résonateur 1.

Deux caractéristiques émergent de l'équation 19. D'une part, pour trouver la fréquence de résonance de $a_s$, on doit annuler la partie réelle du dénominateur de l'équation 19. Le paramètre de balayage pour $a_s$ étant $\delta_s$, cette condition est valide pour :

$$\delta_s^3 + \delta_s^2\, \left(2\,\beta\, |a_p|^2 - \delta_p\right) - \delta_s\, \left[\left(3\,\beta\, |a_p|^2 - \delta_p\right)\left(\beta\, |a_p|^2 - \delta_p\right) - \left(\frac{\Delta\omega}{2}\right)^2\right]$$

$$- \left(2\,\beta\, |a_p|^2 - \delta_p\right)\left[\left(3\,\beta\, |a_p|^2 - \delta_p\right)\left(\beta\, |a_p|^2 - \delta_p\right) + \left(\frac{\Delta\omega}{2}\right)^2\right] = 0 \quad (20)$$

où $|A_0|^2$ est développé selon l'équation 18. En résolvant le polynôme du troisième ordre en $\delta_s$, on trouve une seule solution valide correspondant à $\delta_{s,max}$.

D'autre part, le préfacteur de l'équation 17 implique que l'amplitude de $|a_s|$ est modifiée par $|a_p|$. L'effet du couplage entre les excitations entraînées par le signal d'entrée 2 et le signal de pompe 3 n'est pas seulement un décalage de la fréquence mais aussi une amplification. On peut écrire le facteur de gain G associé en comparant l'amplitude de $|a_s|$ en résonance avec et sans la composante additionnelle $f_{L,p}$ (cas d'un signal d'entrée 2 seul, dit standard, au numérateur de l'équation 21, et cas d'un signal d'entrée 2 additionné à un signal de pompe 3, dit pompé, ou *pumped* en anglais, au dénominateur de l'équation 21) :

$$G = \frac{|a_{s,standard}|}{|a_{s,pumped}|} = \frac{1}{1 - |A_0|^2} \tag{21}$$

Dans ce mode de réalisation, on utilise l'auto-couplage pour amplifier le signal d'entrée 2 par un signal de pompe 3, d'amplitude supérieure : c'est ce qui définit la technique d'auto-pompage. Le signal de sortie du résonateur 1 est un signal d'entrée 2 amplifié, et de fréquence de résonance sensiblement différente, décalé et sans non-linéarité.

La figure 6 illustre l'amplitude du résonateur en fonction de la fréquence d'oscillation, le résonateur étant actionné selon un mode de réalisation de l'invention. Le signal d'entrée 2 de pulsation $\omega_s$ proche de $\omega_0$ est additionné au signal de pompe 3 de pulsation $\omega_s$ proche de $\omega_0$ et différent de $\omega_p$. Le signal résultant de l'addition du signal d'entrée 2 et du signal de pompe 3 est transduit au résonateur mécanique. Dans ce mode de réalisation, on mesure l'amplitude de l'oscillation de sortie, c'est-à-dire du résonateur 1. Cette mesure peut être réalisée de manière optique, électromagnétique ou électrostatique. La courbe (f) illustre la valeur absolue de $a_p$. La flèche noire en haut à droite de la figure indique la fréquence $\omega_p$ utilisée comme point de travail du signal de pompe 3 pour injecter le signal d'entrée 2 (illustré par la courbe (g), dont la fréquence est décalée pour permettre une comparaison visible dans la figure 6). La courbe (h) illustre la ligne de résonance correspondant à $|a_s|$. Cette ligne de résonance est centrée sur $\omega_p + \delta_{s,max}$. Plus généralement, cette ligne de résonance est centrée sur une pulsation proche de $\omega_p$. Le facteur de gain de l'équation 21 est égal dans ce mode de réalisation à 20, ce qui équivaut à une amplification de 26 dB. L'allure de la courbe (h) est lorentzienne et de largeur (ou dissipation) $\Delta\omega$. Dans ce mode de réalisation de l'invention, la dissipation effective liée à la composante $|a_s|$ est sensiblement égale à la dissipation effective mesurée quand on actionne le résonateur seulement avec le signal d'entrée 2, et l'amplitude $|a_s|$ est sensiblement plus élevée.

Préférentiellement, on choisit, lors de l'amplification, $\delta_s > 0$ si $\gamma$ (c'est-à-dire $\gamma_n$ dans ce cas) est strictement supérieur à 0. En effet, on sort du cadre de l'auto-pompage dans le cas $\delta_s = 0$ ($\omega_s = \omega_p$). Le résonateur est dans ce cas actionné à la fréquence $\omega_s$ avec une force égale à $f_{L,s} + f_{L,p}$. Ce cas particulier d'excitation peut entraîner une transition de $a_p$ passant d'amplitudes élevées à des amplitudes faibles. La probabilité d'un tel événement de relaxation augmente en se rapprochant de la pulsation de bifurcation réduite $\delta_{p,max}$ de $a_p$ et entraîne une limitation pratique du gain maximum atteignable par ce procédé, si l'ensemble des autres paramètres est gardé constant. Cette limitation du gain peut par exemple être compensée par une augmentation de l'amplitude du signal de pompe 3.

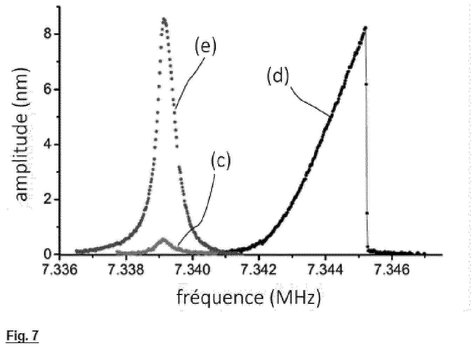

La figure 7 illustre une amplification linéaire selon un mode de réalisation de l'invention. Dans les modes de réalisation décrit précédemment, le signal $a_s$ est considéré comme linéaire car l'excitation $f_{L,s}$ est très petite. Dans un mode de réalisation particulier de l'invention, l'augmentation de l'amplitude de $a_s$ par amplification peut correspondre à des amplitudes pour lesquelles le résonateur oscille, hors du cadre de l'auto-pompage, de manière non-linéaire et particulièrement selon une équation de Duffing. On peut exprimer analytiquement les expressions de $a_p$, $a_s$ et $a_i$ en dérivant le terme non-linéaire de plus bas ordre dans les équations 11, 12 et 13 par rapport à $a_s$, en introduisant l'expression standard de Duffing. On obtient :

$$e^{i\,0} \;:\; a_p = \frac{f_{L,p}}{2\,\omega_0} \frac{1}{\beta\left(|a_p|^2 + 2\,|a_s|^2 + 2\,|a_i|^2 + 2\,a_s\,a_i\,e^{i\,\phi_P}\right) - \delta_p + i\frac{\Delta\omega}{2}} \tag{22}$$

$$e^{i\,\delta_s} \;:\; a_s = \frac{\frac{f_{L,s}\,e^{i\,\delta\phi}}{2\,\omega_0} - \beta\,a_p^2\,a_i^\star}{\beta\left(2\,|a_p|^2 + |a_s|^2 + 2\,|a_i|^2\right) - \delta_p - \delta_s + i\frac{\Delta\omega}{2}} \tag{23}$$

$$e^{-i\,\delta_s} \;:\; a_i = \frac{-\beta\,a_p^2\,a_s^\star}{\beta\left(2\,|a_p|^2 + 2\,|a_s|^2 + |a_i|^2\right) - \delta_p + \delta_s + i\frac{\Delta\omega}{2}} \tag{24}$$

où $\phi_p$ est défini par $a_p^\star = a_p\,e^{i\,\phi_p}$ . Les équations 22, 23 et 24 sont dans ce cas couplées entre elles. Avec les notations employées précédemment, on a :

$$a_p = \frac{f_{L,p}}{2\,\omega_0}\,\frac{1}{\beta\left[|a_p|^2 + 2\,|a_s|^2\left(1 + |A|^2 - A\right)\right] - \delta_p + i\,\frac{\Delta\omega}{2}} \qquad (25)$$

$$a_s = \frac{f_{L,s}\,e^{i\,\delta\phi}}{2\,\omega_0}\,\frac{1}{1 - |A|^2}$$
$$\times\;\frac{1}{\frac{1+|A|^2}{1-|A|^2}\left(\beta\,|a_s|^2\left(1 - |A|^2\right) - \delta\right) + 2\,\beta\,|a_p|^2 - \delta_p + i\,\frac{\Delta\omega}{2}} \qquad (26)$$

$$a_i = -A\,e^{-i\,\phi_p}\,as^\star \qquad (27)$$

avec:

$$A = \frac{\beta\,|a_p|^2}{\beta\left[2\,|a_p|^2 + |a_s|^2\left(2 + |A|^2\right)\right] - \delta_p + \delta_s + i\,\frac{\Delta\omega}{2}} \qquad (28)$$

Les inventeurs ont découvert que dans ces conditions, la dépendance non-linéaire des variables en fonction d'autres variables s'atténue, voir s'annule expérimentalement, en particulier concernant les dépendances non-linéaires de $a_s$. La figure 7 illustre une amplification linéaire dans ces conditions. La courbe (e) de la figure 7 correspond à la ligne de résonance de la$|a_s|$, dans des conditions de pompage de grande amplitude, et ayant pour conséquence une grande amplitude de la$|a_p|$. Dans ce mode de réalisation, la$|a_p|$ peut être inférieure ou égale à 90 nm et/ou supérieure ou égale à l'épaisseur des couches du résonateur 1. Les inventeurs ont également découvert que le comportement de la$|a_s|$ est linéaire. A titre de comparaison, la courbe (d) de la figure 7 (dont la fréquence est décalée pour la clarté de la figure) illustre une excitation simple du résonateur 1, dont la force est adaptée à atteindre la même amplitude que la$|a_s|$ : la ligne de résonance de la courbe (d) correspond à un comportement d'un oscillateur en régime de Duffing. Dans ce mode de réalisation, la dynamique linéaire du système est amplifiée par un facteur 5.

Ces résultats illustrent la capacité de ce mode de réalisation, en régime d'auto-pompage, à amplifier l'amplitude du signal tout en augmentant la gamme dynamique linéaire du système. L'augmentation de cette gamme dynamique peut être directement appliquée à des systèmes de détection par exemple.

Les modes de réalisation d'actionnement linéaire et/ou d'amplification linéaire décrits présentent l'avantage de ne pas recourir à un ajustement électromécanique effectué par une grille capacitive permettant de compenser les non-linéarités tel que décrit dans l'art antérieur. Ces modes de réalisations sont compatibles avec un ajustement simultané de la fréquence de résonance induite par une grille polarisée. En particulier, dans un mode de réalisation de l'invention, on peut ajuster la fréquence du mode par la polarisation d'une électrode couplée au résonateur 1.

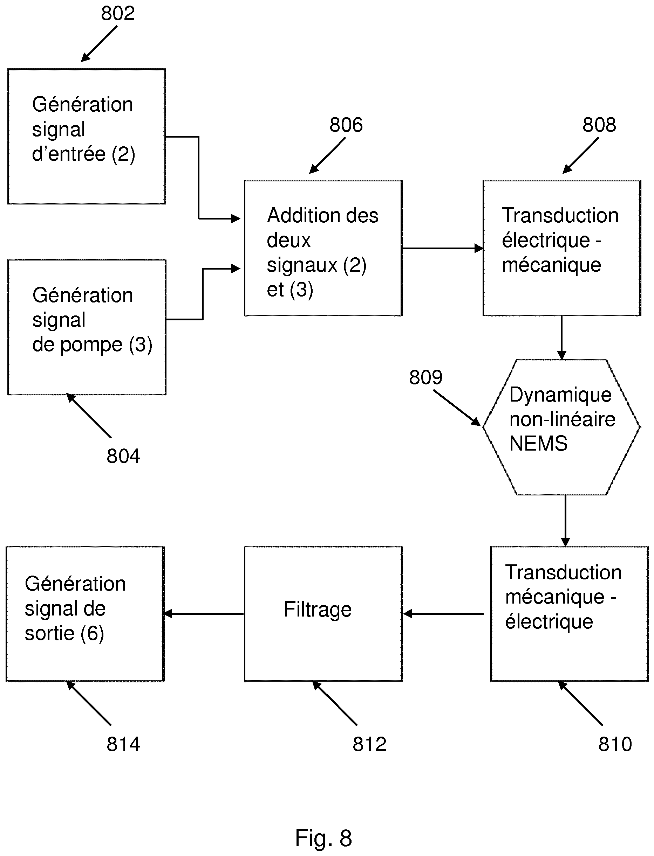

La figure 8 illustre les étapes du procédé d'amplification électromécanique de l'invention dans un mode de réalisation appliqué à un résonateur mécanique 1 de pulsation $\omega_0$. D'une manière générale le procédé consiste à générer (802) un premier signal d'entrée 2 de première amplitude et de première pulsation $\omega_s$ et générer (804) un second signal de pompe 3 de seconde amplitude supérieure à la première amplitude et de seconde pulsation $\omega_p$ différente de la première. Les pulsations des deux signaux d'entrée et de pompe sont proches de la pulsation $\omega_0$ du résonateur mécanique. Le signal de pompe 3 est choisi dans une plage de pulsations $\omega_p$ et d'amplitude où le résonateur est actionné en régime non-linéaire.

La différence $\delta_s$ entre la première et la seconde pulsation, définie par « $\omega_s$ - $\omega_p$ » est au moins cinquante fois inférieure à la pulsation $\omega_0$ du résonateur, et la différence $\delta_p$ entre la seconde pulsation et la pulsation $\omega_0$ du résonateur, définie par « $\omega_p$ - $\omega_0$ est au moins cinquante fois inférieure à la pulsation $\omega_0$ du résonateur.

Les deux signaux d'entrée et de pompe sont ensuite additionnés (étape 806). Le signal électrique résultant est dans une étape suivante (808) transduit au résonateur mécanique (1), ce qui actionne (809) des oscillations non-linéaires du résonateur.

Les oscillations non-linéaires du résonateur suivent une équation différentielle non-linéaire de Duffing, et le coefficient de Duffing est non nul.

Dans une étape suivante (810), le procédé permet que les oscillations non-linéaires du résonateur soient transduites en un signal électrique, qui est filtré (812) pour obtenir un signal de sortie (6). L'amplitude Z des oscillations après le filtrage est mesurée sensiblement à la pulsation « $\omega_p + \delta_s$ ».

Z L'étape de filtrage est effectuée avec un filtre passe-bande dont la bande passante est centrée sur une pulsation proche de la pulsation $\omega_0$ du résonateur mécanique ou sur une pulsation sensiblement de $\omega_p + \delta_s$.

La mise en œuvre du procédé permet de générer un signal de sortie 6 qui est amplifié, l'amplitude des oscillations mesurée après l'étape de filtrage variant linéairement avec le premier signal d'entrée 2 à la pulsation $\omega_s$, et le mode de résonance obtenu est celui d'une résonance linéaire.

**Revendications**

1. Procédé d'amplification électromécanique comprenant au moins :

   - une première étape de transduction consistant à transduire un signal électrique à un résonateur mécanique (1) de type microsystème ou nanosystème ayant un mode de résonance mécanique de pulsation $\omega_0$, ledit signal électrique actionnant des oscillations non-linéaires du résonateur suivant une équation différentielle non-linéaire de Duffing avec un coefficient de Duffing non nul ;
   - une deuxième étape de transduction consistant à transduire lesdites oscillations non-linéaires du résonateur en un signal électrique transduit; et
   - une étape de filtrage consistant à filtrer ledit signal électrique transduit pour obtenir un signal de sortie (6) ; où
   - le signal transduit au résonateur lors de la première étape de transduction est obtenu en additionnant un premier signal d'entrée (2) de première amplitude et de première pulsation $\omega_s$ et un second signal de pompe (3) de seconde amplitude supérieure à la première amplitude et de seconde pulsation $\omega_p$ différente de la première pulsation, les première et seconde pulsations étant proches de la pulsation $\omega_0$ du résonateur mécanique, le second signal de pompe (3) étant choisi dans une plage de pulsations $\omega_p$ et d'amplitude où le résonateur est actionné en régime non-linéaire ; et
   - le signal de sortie (6) est amplifié,
   le procédé étant **caractérisé en ce que**: J l'amplitude des oscillations mesurée après

   le filtrage variant linéairement avec le premier signal d'entrée à la pulsation $\omega_s$, et le mode de résonance obtenu est celui d'une résonance linéaire,
   et **en ce que** la différence $\delta_s$ entre la première et la seconde pulsation, définie par « $\omega_s - \omega_p$ » est au moins cinquante fois inférieure à la pulsation $\omega_0$ du résonateur, et la différence $\delta_\rho$ entre la seconde pulsation et la pulsation $\omega_0$ du résonateur, définie par « $\omega_p - \omega_0$ » est au moins cinquante fois inférieure à la pulsation $\omega_0$ du résonateur ;
   et **en ce que** l'étape de filtrage est effectuée avec un filtre passe-bande dont la bande passante est centrée sur la pulsation $\omega_0$ du résonateur mécanique ou sur une pulsation de $\omega_p + \delta_s$ , l'amplitude des oscillations après le filtrage étant mesurée à la pulsation « $\omega_p + \delta_s$ ».

2. Un dispositif d'amplification électromécanique comportant au moins un résonateur mécanique (1) de type microsystème ou nanosystème ayant un mode de résonance mécanique de pulsation $\omega_0$, le dispositif comprenant de plus :

   - un additionneur (5) de signaux électriques, apte à additionner un premier signal d'entrée (2) de première amplitude et de première pulsation $\omega_s$ et un second signal de pompe (3) de seconde amplitude supérieure à la première amplitude et de seconde pulsation $\omega_p$ différente de la première pulsation, les première et seconde pulsations étant proches de la pulsation $\omega_0$ du résonateur mécanique, le second signal de pompe (3) étant choisi dans une plage de pulsations $\omega_p$ et d'amplitude où le résonateur est actionné en régime non-linéaire ; la différence $\delta_s$ entre la première et la seconde pulsation, définie par «$\omega_s - \omega_p$ » étant au moins cinquante fois inférieure à la pulsation $\omega_0$ du résonateur, et la différence $\delta_\rho$ entre la seconde pulsation et la pulsation $\omega_0$ du résonateur, définie par « $\omega_p - \omega_0$ » étant au moins cinquante fois inférieure à la pulsation $\omega_0$ du résonateur ;
   - un premier transducteur électromécanique relié d'une part électriquement à la sortie dudit additionneur (5) et d'autre part mécaniquement audit résonateur mécanique (1), le premier transducteur étant adapté à transduire le signal électrique en sortie de l'additionneur au résonateur mécanique pour actionner des oscillations non-linéaires du résonateur suivant une équation différentielle non-linéaire de Duffing avec un coefficient de Duffing non nul ;

- un second transducteur électromécanique connecté d'une part mécaniquement audit résonateur mécanique (1) et d'autre part électriquement à un filtre (4), le second transducteur étant adapté à transduire lesdites oscillations non-linéaires du résonateur en un signal électrique transduit ; et
- un filtre (4) de signaux électriques apte à filtrer ledit signal électrique transduit pour obtenir un signal de sortie (6), ledit signal de sortie étant amplifié, l'amplitude des oscillations mesurée à la pulsation « $\omega_p + \delta_s$ » à la sortie du filtre variant linéairement avec le premier signal d'entrée à la pulsation $\omega_s$, et le mode de résonance obtenu est celui d'une résonance linéaire ; le filtre étant un filtre passe-bande dont la bande passante est centrée sur la pulsation $\omega_0$ du résonateur mécanique ou sur une pulsation de $\omega_p + \delta_s$.

3. Le dispositif selon la revendication 2 dans lequel ladite bande passante dudit filtre (4) est centrée sur la pulsation $\omega_0$ du résonateur mécanique.

4. Le dispositif selon la revendication 2 ou 3 dans lequel au moins deux éléments choisis parmi ledit additionneur (5), ledit filtre (4), ledit premier transducteur mécanique et ledit second transducteur électromécanique sont intégrés de manière monolithique.

5. Le dispositif selon l'une quelconque des revendications 2 à 4 comprenant de plus un générateur électrique pour générer ledit signal de pompe (3).

6. Le dispositif selon la revendication 5 dans lequel au moins un transducteur choisi parmi ledit premier transducteur et ledit second transducteur sont adaptés à transduire de l'énergie par un travail de forces de Laplace ou de forces de Lorentz.

7. Le dispositif selon l'une quelconque des revendications 2 à 6 dans lequel au moins un transducteur choisi parmi ledit premier transducteur et ledit second transducteur sont adaptés à transduire de l'énergie par un effet choisi parmi un effet piézoélectrique et piézorésistif.

**Patentansprüche**

1. Verfahren zur elektromechanischen Verstärkung, zumindest umfassend:

   - einen ersten Übertragungsschritt, der darin besteht, ein elektrisches Signal an einen mechanischen Resonator (1) vom Typ eines Mikrosystems oder eines Nanosystems mit einer mechanischen Resonanzmode mit Puls $\omega_0$ zu übertragen, wobei das elektrische Signal nichtlineare Schwingungen des Resonators gemäß einer nichtlinearen Duffing-Differenzialgleichung mit einem Duffing-Koeffizienten ungleich Null bewirkt;
   - einen zweiten Übertragungsschritt, der darin besteht, diese nichtlinearen Schwingungen des Resonators in ein übertragenes elektrisches Signal zu übersetzen; und
   - einen Filterschritt, der darin besteht, das übertragene elektrische Signal auszufiltern, um ein Ausgangssignal (6) zu erhalten;

   wobei

   - das im ersten Übertragungsschritt zum Resonator übertragene Signal durch Summieren eines ersten Eingangssignals (2) mit einer ersten Amplitude und einem ersten Puls $\omega_s$ und eines zweiten Pumpsignals (3) mit einer zweiten Amplitude, die größer als die erste Amplitude ist, und einem zweiten Puls $\omega_p$, der sich von dem ersten Puls unterscheidet, erhalten wird, wobei der erste und der zweite Puls nahe bei dem Puls $\omega_0$ des mechanischen Resonators liegen, wobei das zweite Pumpsignal (3) aus einem Bereich von Pulsen $\omega_p$ und Amplitude ausgewählt wird, in dem der Resonator in einem nichtlinearen Regime betrieben wird; und
   - das Ausgangssignal (6) verstärkt wird,

   wobei das Verfahren **dadurch gekennzeichnet ist, dass** die nach der Filterung gemessene Amplitude der Schwingungen linear mit dem ersten Eingangssignal bei dem Puls $\omega_s$ variiert, und die erhaltende Resonanzmode die einer linearen Resonanz ist,

   und dass die Differenz $\delta_s$ zwischen dem ersten und dem zweiten Puls, definiert als "$\omega_s - \omega_p$", mindestens fünfzigmal kleiner ist als der Puls $\omega_0$ des Resonators, und die Differenz $\delta_p$ zwischen dem zweiten Puls und dem

Puls $\omega_0$ des Resonators, definiert als "$\omega_p - \omega_0$", mindestens fünfzigmal kleiner ist als der Puls $\omega_0$ des Resonators; und dass der Filterschritt mit einem Bandpassfilter durchgeführt wird, dessen Bandbreite auf den Puls $\omega_0$ des mechanischen Resonators oder auf einen Puls von $\omega_p + \delta_s$ zentriert ist, wobei die Amplitude der Schwingungen nach der Filterung bei dem Puls "$\omega_p + \delta_s$" gemessen wird.

**2.** Vorrichtung zur elektromechanischen Verstärkung mit mindestens einem mechanischen Resonator (1) vom Typ eines Mikrosystems oder eines Nanosystems mit einer mechanischen Resonanzmode mit dem Puls $\omega_0$, wobei die Vorrichtung ferner enthält:

- einen Addierer (5) für elektrische Signale, der geeignet ist, ein erstes Eingangssignal (2) mit einer ersten Amplitude und einem ersten Puls $\omega_s$ und ein zweites Pumpsignal (3) mit einer zweiten Amplitude, die größer ist als die erste Amplitude, und mit einem zweiten Puls $\omega_p$, der sich von dem ersten Puls unterscheidet, zu summieren, wobei der erste und der zweite Puls nahe bei dem Puls $\omega_0$ des mechanischen Resonators liegen, wobei das zweite Pumpsignal (3) aus einem Bereich von Pulsen $\omega_p$ und Amplitude ausgewählt ist, in dem der Resonator in einem nichtlinearen Regime betrieben wird; wobei die Differenz $\delta_s$ zwischen dem ersten und dem zweiten Puls, definiert als "$\omega_s - \omega_p$", mindestens fünfzigmal kleiner ist als der Puls $\omega_0$ des Resonators, und die Differenz $\delta_s$ zwischen dem zweiten Puls und dem Puls $\omega_0$ des Resonators, definiert als "$\omega_p - \omega_0$", mindestens fünfzigmal kleiner ist als der Puls $\omega_0$ des Resonators;
- einen ersten elektromechanischen Wandler, der einerseits elektrisch mit dem Ausgang des Addierers (5) und andererseits mechanisch mit dem mechanischen Resonator (1) verbunden ist, wobei der erste Wandler dazu ausgelegt ist, das elektrische Signal am Ausgang des Summierers an den mechanischen Resonator zu übertragen, um nichtlineare Schwingungen des Resonators gemäß einer nichtlinearen Duffing-Differenzialgleichung mit einem Duffing-Koeffizienten ungleich Null zu bewirken;
- einen zweiten elektromechanischen Wandler, der einerseits mechanisch mit dem mechanischen Resonator (1) und andererseits elektrisch mit einem Filter (4) verbunden ist, wobei der zweite Wandler dazu geeignet ist, die nichtlinearen Schwingungen des Resonators in ein transduziertes elektrisches Signal zu übertragen; und
- ein Filter (4) für elektrische Signale, das geeignet ist, das übertragene elektrische Signal auszufiltern, um ein Ausgangssignal (6) zu erhalten, wobei das Ausgangssignal verstärkt wird, wobei die Amplitude der Schwingungen, die bei dem Puls "$\omega_p + \delta_s$" am Ausgang des Filters gemessen wird, linear mit dem ersten Eingangssignal bei dem Puls $\omega_s$ variiert, und die erhaltene Resonanzmode die einer linearen Resonanz ist; wobei das Filter ein Bandpassfilter ist, dessen Bandbreite auf den Puls $\omega_0$ des mechanischen Resonators oder auf einen Puls von $\omega_p + \delta_s$ zentriert ist.

**3.** Vorrichtung nach Anspruch 2, wobei die Bandbreite des Filters (4) auf den Puls $\omega_0$ des mechanischen Resonators zentriert ist.

**4.** Vorrichtung nach Anspruch 2 oder 3, wobei mindestens zwei Elemente, ausgewählt aus Addierer (5), Filter (4), mechanischem ersten Wandler und elektromechanischem zweiten Wandler, monolithisch integriert sind.

**5.** Vorrichtung nach einem der Ansprüche 2 bis 4, ferner enthaltend einen elektrischen Generator zum Erzeugen des Pumpsignals (3).

**6.** Vorrichtung nach Anspruch 5, wobei mindestens ein Wandler, ausgewählt aus erstem Wandler und zweitem Wandler, dazu geeignet ist, Energie durch die Arbeit von Laplace-Kräften oder Lorentz-Kräften zu übertragen.

**7.** Vorrichtung nach einem der Ansprüche 2 bis 6, wobei mindestens ein Wandler, ausgewählt aus erstem Wandler und zweitem Wandler, dazu geeignet ist, Energie durch einen Effekt, ausgewählt aus piezoelektrischem und piezoresistivem Effekt, zu übertragen.

## Claims

**1.** Electromechanical amplifying method comprising at least:

- a first transducing step consisting in transducing an electrical signal to a microsystem or nanosystem mechanical resonator (1) having a mechanical resonance mode of angular frequency $\omega_0$, said electrical signal actuating nonlinear oscillations of the resonator according to a non-linear differential Duffing equation with a non-zero Duffing coefficient;

- a second transducing step consisting in transducing the non-linear oscillations of the resonator into a transduced electrical signal; and
- a filtering step consisting in filtering said transduced electrical signal to obtain an output signal (6);

wherein

- the signal transduced to the resonator during the first transducing step is obtained by adding a first input signal (2) of a first amplitude and of a first angular frequency $\omega_s$ and a second pump signal (3) of a second amplitude greater than the first amplitude and of a second angular frequency $\omega_\rho$ that is different from the first angular frequency, the first and second angular frequencies being close to the angular frequency $\omega_0$ of the mechanical resonator and the second pump signal (3) being chosen from a range of angular frequencies $\omega_\rho$ and amplitudes in which the resonator is actuated in a non-linear regime; and
- the output signal (6) is amplified,

the method being **characterised in that**:

the amplitude of the oscillations measured after the filtering varying linearly with the first input signal of the angular frequency $\omega_s$ and the resonant mode obtained is that of a linear resonance,
and **in that** the difference $\delta_s$ between the first and second angular frequencies, defined by "$\omega_s - \omega_\rho$" is at least fifty times smaller than the angular frequency $\omega_0$ of the resonator and the difference $\delta_\rho$ between the second angular frequency and
the angular frequency $\omega_0$ of the resonator, defined by "$\omega_\rho - \omega_0$", is at least fifty times smaller than the angular frequency $\omega_0$ of the resonator;
and **in that** the filtering step is performed with a bandpass filter of which the bandwidth is centred on the angular frequency $\omega_0$ of the mechanical resonator or on an angular frequency equal to $\omega_\rho + \delta_s$. the amplitude of the oscillations after filtering being measured at the angular frequency "$\omega_\rho + \delta_s$".

2. An electromechanical amplification device comprising at least one microsystem or nanosystem mechanical resonator (1) having a mechanical resonance mode of angular frequency $\omega_0$, the device also comprising:

- an electrical signal adder (5), able to add a first input signal (2) of a first amplitude and a first angular frequency $\omega_s$ and a second pump signal (3) of a second amplitude greater than the first amplitude and of a second angular frequency $\omega_\rho$ that is different from the first angular frequency, the first and second angular frequencies being close to the angular frequency $\omega_0$ of the mechanical resonator, the second pump signal (3) being chosen from a range of angular frequencies $\omega_\rho$ and amplitudes in which the resonator is actuated in a non-linear regime; the difference $\delta_s$ between the first and second angular frequencies, defined by "$\omega_s - \omega_\rho$" is at least fifty times smaller than the angular frequency $\omega_0$ of the resonator and the difference $\delta_\rho$ between the second angular frequency and the angular frequency $\omega_0$ of the resonator, defined by "$\omega_\rho - \omega_0$", is at least fifty times smaller than the angular frequency $\omega_0$ of the resonator;
- a first electromechanical transducer connected on one hand electrically to the output of the adder (5) and on the other hand mechanically to the mechanical resonator (1), the first transducer being adapted to transduce the electrical signal at the output of the adder to the mechanical resonator in order to actuate nonlinear oscillations of the resonator according to a non-linear differential Duffing equation with a non-zero Duffing coefficient;
- a second electromechanical transducer connected on one hand mechanically to the mechanical resonator (1) and on the other hand electrically to a filter (4), the second transducer being adapted to transduce the non-linear oscillations of the resonator into a transduced electrical signal; and
- an electrical signal filter (4) able to filter the transduced electrical signal to obtain an output signal (6), the output signal being amplified, the amplitude of the oscillations measured at the angular frequency "$\omega_\rho + \delta_s$" at the output of the filter varying linearly with the first input signal of angular frequency $\omega_s$ and the resonant mode obtained is that of a linear resonance; the filtering step being a bandpass filter of which the bandwidth is centred on the angular frequency $\omega_0$ of the mechanical resonator or on an angular frequency equal to $\omega_\rho + \delta_s$..

3. The device according to claim 2 in which the bandwidth of the filter (4) is centred on the angular frequency $\omega_0$ of the mechanical resonator.

4. The device according to claim 2 or 3 in which at least two elements chosen among said adder (5), said filter (4), said first mechanical transducer and said second electromechanical transducer are monolithically integrated.

5. The device according to claims 2 to 4 also comprising an electric generator to generate the pump signal (3).

6. The device according to claim 5 in which at least one transducer chosen between the first transducer and the second transducer is adapted to transduce energy by means of the work done by Laplace forces or Lorentz forces.

7. The device according to any of the claims 2 to 6 in which at least one transducer chosen between the first transducer and the second transducer are adapted to transduce energy by an effect chosen among one piezoelectric and piezoresistive effect.

**Fig. 1**

A

B

**Fig. 2**

**Fig. 3**

**Fig. 4**

**Fig. 5**

**Fig. 6**

**Fig. 7**

802

Génération
signal
d'entrée (2)

806

Addition des
deux
signaux (2)
et (3)

808

Transduction
électrique -
mécanique

Génération
signal
de pompe (3)

804

809

Dynamique
non-linéaire
NEMS

Génération
signal de
sortie (6)

Filtrage

Transduction
mécanique -
électrique

814

812

810

Fig. 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2014312980 A1

**Littérature non-brevet citée dans la description**

- **POSTMA, H. C. ; KOZINSKY, I. ; HUSAIN, A. ; ROUKES, M. L.** Dynamic range of nanotube-and nanowire-based electromechanical systems. *Applied Physics Letters,* 2005, vol. 86 (22), 223105
- **KACEM, N. ; HENTZ, S. ; PINTO, D. ; REIG, B. ; NGUYEN, V.** Nonlinear dynamics of nanomechanical beam resonators: improving the performance of NEMS-based sensors. *Nanotechnology,* 2009, vol. 20 (27), 275501
- **M DEFOORT et al.** *Modal ''self-coupling'' as a sensitive probe for nanomechanical détection,* 23 Novembre 2015, https://arxiv.org/pdf/1511.07273.pdf
- Nonlinear modal coupling in a high-stress doubly-clamped nanomechanical resonator. **K J LULLA et al.** New Journal of Physics. Institute of Physics Publishing, 28 Novembre 2012, vol. 14, 113040

- **CLELAND, A. N. ; ROUKES, M. L.** External control of dissipation in a nanometer-scale radiofrequency mechanical resonator. *Sensors and Actuators A: Physical,* 1999, vol. 72 (3), 256-261
- **WESTRA, H. J. R. ; POOT, M. ; VAN DER ZANT, H. S. J. ; VENSTRA, W. J.** Nonlinear modal interactions in clamped-clamped mechanical resonators. *Physical Review Letters,* 2010, vol. 105 (11), 117205
- **LULLA, K. J. ; COUSINS, R. B. ; VENKATESAN, A. ; PATTON, M. J. ; ARMOUR, A. D. ; MELLOR, C. J. ; OWERS-BRADLEY, J. R.** Nonlinear modal coupling in a high-stress doubly-clamped nanomechanical resonator. *New Journal of Physics,* 2012, vol. 14 (11), 113040